# EUROPEAN PATENT APPLICATION

(11) **EP 2 474 983 A1**
(43) Date of publication of application: **11.07.2012**
(21) Application number: 10811638.5
(22) Date of filing: 26.07.2010
(51) Int. Cl.: H01B 1/22, H01B 1/00, H01B 5/14, H01L 31/04

(54) **ELECTRICALLY CONDUCTIVE PASTE, ELECTRODE FOR SEMICONDUCTOR DEVICE, SEMICONDUCTOR DEVICE, AND PROCESS FOR PRODUCTION OF SEMICONDUCTOR DEVICE**

(30) Priority: 31.08.2009 JP 2009200189
(71) Applicant: Sharp Kabushiki Kaisha, Osaka-shi, Osaka 545-8522 (JP)
(72) Inventor: TANAKA, Satoshi, Osaka-shi Osaka 545-8522 (JP); YAMAMOTO, Shinya, Osaki-shi Osaka 545-8522 (JP)
(74) Representative: Müller-Boré & Partner Patentanwälte
(86) International application number: PCT/JP2010/062525
(87) International publication number: WO 2011/024587

(57) **Abstract**

Disclosed are an electrically conductive paste (7) containing an electrically conductive powder including electrically conductive particles (21), wherein the electrically conductive particles (21) each have a basic material (21a), and an electrically conductive layer (21b) covering at least one portion of the outer surface of the basic material (21a); an electrode (71, 72, 81, 82), for a semiconductor device, formed by use of the paste; a semiconductor device (10, 35); and a method for producing the semiconductor device (10, 35) by use of the paste.

## Description

### TECHNICAL FIELD

The present invention relates to an electrically conductive paste, an electrode for a semiconductor device, a semiconductor device, and a method for producing a semiconductor device.

### BACKGROUND ART

In recent years, from the viewpoint of global environmental problems, such as a problem of the exhaustion of energy resources and an increase in CO₂ in the atmosphere, clean energy has been desired to be developed. Solar photoelectric generation using, in particular, solar cells out of semiconductor devices has been developed and has been put into practical use as a new energy source, and have been expanding.

Hitherto, the main current of solar cells has been solar cells of a double-sided electrode type, which are produced, for example, by diffusing, into a light-receiving surface of a monocrystal or polycrystal silicon substrate, an impurity of a conduction type reverse to the conduction type of the silicon substrate, thereby forming a pn junction, and then forming electrodes onto the light-receiving surface of the silicon substrate, and the back surface thereof, which is at the side reverse to the light-receiving surface side, respectively (see, for example, Japanese Patent Application Laying-Open No. 2007-234884 (Patent Literature 1)). In double-sided electrode type solar cells, it is general to diffuse, into the back surface of their silicon substrate, an impurity of a conduction type identical with that of the silicon substrate to give a high concentration, thereby attaining a high power by back-surface field effect.

Researches have been advanced also about back electrode type solar cells, in each of which an electrode is not formed on the light-receiving surface of a silicon substrate and is formed only on the back surface thereof (see, for example, Japanese Patent Application Laying-Open No. 2006-332273 (Patent Literature 2)).

Hereinafter, a description will be made about a method for producing a solar cell described in Patent Literature 1 with reference to schematic sectional views of Fig. 14(a) to Fig. 14(f).

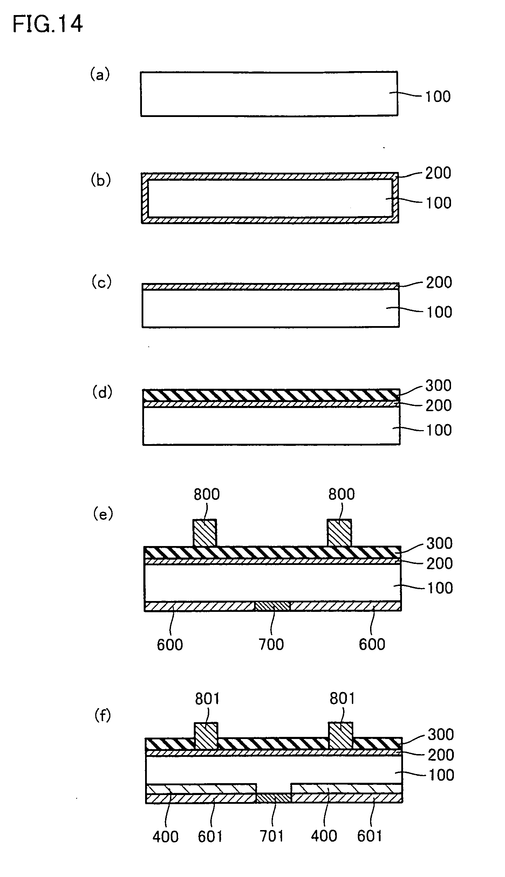

As illustrated in Fig. 14(a), a p-type silicon substrate 100 is first prepared. Next, as illustrated in Fig. 14(b), phosphorus, which is an n-type dopant, is diffused into all surfaces of p-type silicon substrate 100 to form an n-type dopant diffused layer 200 in all the surfaces of p-type silicon substrate 100.

Next, as illustrated in Fig. 14(c), n-type dopant diffused layer 200 is partially removed to cause n-type dopant diffused layer 200 formed in all the surfaces of p-type silicon substrate 100 to remain only throughout a surface that is to be a light-receiving surface of p-type silicon substrate 100. The removal of n-type dopant diffused layer 200 can be attained by protecting, with a resist, the light-receiving surface of p-type silicon substrate 100 after the formation of n-type dopant diffused layer 200, then subjecting n-type dopant diffused layer 200 not protected with the resist to etching treatment, and subsequently removing the remaining resist with an organic solvent or some other.

Next, as illustrated in Fig. 14(d), a silicon nitride film 300 functioning as an anti-reflecting film is formed on n-type dopant diffused layer 200 in the surface of the p-type silicon substrate 100. Silicon nitride layer 300 may be formed by pressure-reduced thermal CVD, or plasma CVD.

Next, as illustrated in Fig. 14(e), an aluminum paste 600 and a silver paste 700 for backside are each screen-printed onto desired positions of the back surface of p-type silicon substrate 100, which is a surface reverse to the light-receiving surface of p-type silicon substrate 100, and then dried. Furthermore, a silver paste 800 for the light-receiving surface is screen-printed onto desired positions of the front surface of silicon nitride film 300, and then dried.

Thereafter, p-type silicon substrate 100 is fired at 800 to 850°C in a dry air atmosphere inside a near infrared furnace for several minutes to ten plus several minutes, whereby as illustrated in Fig. 14(f), a light-receiving surface silver electrode 801 is formed on n-type dopant diffused layer 200 extending throughout the light-receiving surface of p-type silicon substrate 100, and further a backside aluminum electrode 601 and a backside silver electrode 701 are formed on the back surface of p-type silicon substrate 100.

At the light-receiving surface side of p-type silicon substrate 100, silver paste 800 for the light-receiving surface is fired through during the firing so that silver paste 800 penetrates silicon nitride film 300 to turn to light-receiving silver electrode 801, which electrically contacts n-type dopant diffused layer 200 in the front surface of p-type silicon substrate 100, after the firing.

At the back surface side of p-type silicon substrate 100, aluminum, which is a p-type dopant, diffuses from aluminum paste 600 to the back surface of p-type silicon substrate 100 during the firing, so that a p-type dopant diffused layer 400 is formed in the back surface of p-type silicon substrate 100. After the firing, therefore, aluminum paste 600 turns to backside aluminum electrode 601, and further silver paste 700 for backside turns to backside silver electrode 701.

As described above, the solar cell described in Patent Literature 1 can be produced.

### CITATION LIST

### PATENT LITERATURE

PTL 1: Japanese Patent Application Laying-Open No. 2007-234884
PTL 2: Japanese Patent Application Laying-Open No. 2006-332273

### SUMMARY OF INVENTION

### TECHNICAL PROBLEM

In recent years, crystal type solar cells each using a monocrystal or polycrystal silicon substrate have been desired to be produced at lower costs with excellent properties.

In the production of any crystal type solar cell, silver paste used to form the its - silver electrode is the highest in cost. Thus, in order to produce the crystal type solar cell at low costs, it is most effective to decrease the use amount of the silver paste. However, when the use amount of the silver paste is decreased, the series resistance of the silver electrode is increased so that properties of the solar cell are declined.

Thus, while various attempts have been made for restraining a decline in properties of a solar cell while decreasing the use amount of a silver paste therefor. However, recently, the attempts have reached to a limit.

This problem is not a problem limited to crystal type solar cells so as to be common also to other semiconductor devices.

In light of the situation, an object of the invention is to provide an electrically conductive paste, and an electrode for a semiconductor device that can each be produced at low costs while the paste or the electrode can restrain properties of a semiconductor device from being declined; a semiconductor device; and a method for producing a semiconductor device.

### SOLUTION TO PROBLEM

The invention is an electrically conductive paste containing an electrically conductive powder including electrically conductive particles, wherein the electrically conductive particles each have a basic material, and an electrically conductive layer covering at least one portion of the outer surface of the basic material.

The electrically conductive paste of the invention may further contain a silver powder including silver particles.

The invention is also an electrode, for a semiconductor device, containing electrically conductive particles, wherein the electrically conductive particles each have a basic material, and an electrically conductive layer covering at least one portion of the outer surface of the basic material.

The invention is also a semiconductor device containing a semiconductor substrate, and an electrode, for the semiconductor device, that is set over a surface of the semiconductor substrate, wherein the electrode, for the semiconductor device, contains a plurality of electrically conductive particles, and the electrically conductive particles each have a basic material, and an electrically conductive layer covering at least one portion of the outer surface of the basic material.

The invention is also a method for producing a semiconductor device, including the steps: applying an electrically conductive paste containing an electrically conductive powder including electrically conductive particles to a semiconductor substrate, and firing the electrically conductive paste.

### ADVANTAGEOUS EFFECTS OF INVENTION

According to the invention, provided are an electrically conductive paste, and an electrode for a semiconductor device that can each be produced at low costs while the paste or the electrode can restrain properties of a semiconductor device from being declined; a semiconductor device; and a method for producing a semiconductor device.

### BRIEF DESCRIPTION OF DRAWINGS

Fig. 1(a) to Fig. 1(h) are schematic sectional views illustrating a method for producing a solar cell of Embodiment 1.
Fig. 2 is a schematic sectional view illustrating an example of an electrically conductive paste applied onto a surface of a p-type silicon substrate.
Fig. 3 is a schematic sectional view of an example of any one of electrically conductive particles contained in the electrically conductive paste.
Fig. 4 is a schematic plan view of a light-receiving surface of the solar cell of Embodiment 1.
Fig. 5 is a schematic plan view of the back surface of the solar cell of Embodiment 1.
Fig. 6 is a schematic perspective view illustrating a partial production process of an example of a method for producing a solar cell module by use of the solar cell of Embodiment 1.
Fig. 7 is a schematic perspective view illustrating another partial production process of the example of the method for producing the solar cell module by use of the solar cell of Embodiment 1.
Fig. 8 is a schematic perspective view illustrating still another partial production process of the example of the method for producing the solar cell module by use of the solar cell of Embodiment 1.
Fig. 9 is a schematic perspective view illustrating a further partial production process of the example of the method for producing the solar cell module by use of the solar cell of Embodiment 1.
Fig. 10 is a schematic sectional view of an example of a solar cell module wherein solar cells of Embodiment 1 are used.
Fig. 11 is a schematic side view of an example of the structure obtained by fitting an aluminum frame and others to the solar cell module illustrated in Fig. 10.
Fig. 12(a) to Fig. 12(h) are schematic sectional views illustrating a method for producing a solar cell of Embodiment 2.
Fig. 13(a) to Fig. 13(h) are schematic sectional views illustrating a method for producing a solar cell of Embodiment 3.
Fig. 14(a) to Fig. 14(f) are schematic sectional views illustrating a method for producing a solar cell described in Patent Literature 1.

### DESCRIPTION OF EMBODIMENTS

Hereinafter, embodiments of the invention will be described. In the drawings attached for the invention, the same reference numbers show the same members or portions, or members or portions corresponding to each other.

### <Embodiment 1>

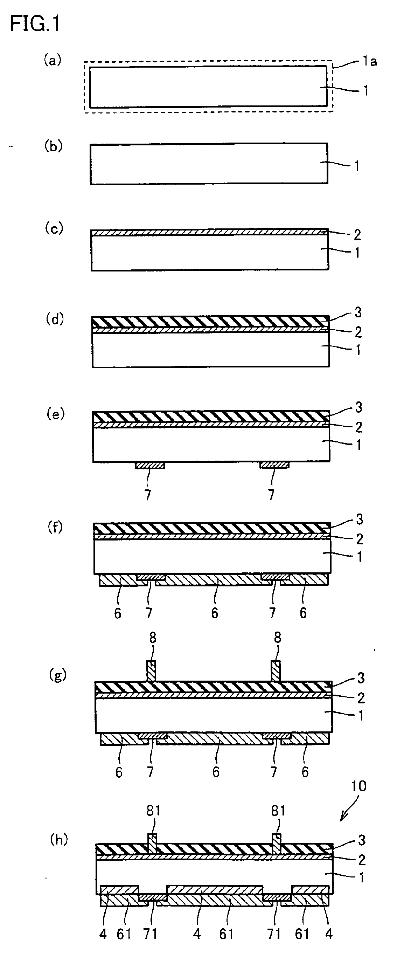

Fig. 1(a) to Fig. 1(h) illustrate schematic sectional views illustrating a method for producing a solar cell of Embodiment 1.

As illustrated in Fig. 1(a), a monocrystal or polycrystal p-type silicon ingot is first sliced by means of, for example, a wire saw to yield a p-type silicon substrate 1. Throughout all surfaces of p-type silicon substrate 1, a damage layer 1a is formed which is generated when the silicon ingot is sliced.

Next, as illustrated in Fig. 1(b), all the surfaces of p-type silicon substrate 1 are etched to remove damage layer 1a formed throughout all the surfaces of p-type silicon substrate 1. By adjusting conditions for the etching, fine irregularities, such as texture structures, can be made in the surfaces of p-type silicon substrate 1. When the fine irregularities are made in the surfaces of p-type silicon substrate 1 in this way, the reflection of sunlight radiated into the surfaces of p-type silicon substrate 1 that have the fine irregularities can be decreased so that the solar cell can be improved in conversion efficiency.

Next, as illustrated in Fig. 1(c), an n-type dopant diffused layer 2 is formed throughout one of two main surfaces (hereinafter referred to as the first main surface) each having the largest area, out of the surfaces of p-type silicon substrate 1. n-Type dopant diffused layer 2 may be formed by gas-phase diffusion using a gas that contains phosphorus, which is an n-type dopant, such as POCl₃, application diffusion using a dopant liquid that contains a phosphorus compound, or some other method. When a phosphorus silicate glass layer is formed throughout the first main surface of p-type silicon substrate 1 by the diffusion of phosphorus, the phosphorus silicate glass layer is removed by, for example, acid treatment.

Next, as illustrated in Fig. 1(d), an anti-reflecting layer 3 is formed on n-type dopant diffused layer 2 in the first main surface of p-type silicon substrate 1. Anti-reflecting layer 3 may be formed by, for example, a method of forming a silicon nitride layer by use of plasma CVD, a method of forming a titanium oxide layer by use of normal-pressure CVD, or the like.

Next, as illustrated in Fig. 1(e), an electroconductive paste 7 is applied onto the second main surface of p-type silicon substrate 1, which is a surface reverse to the first main surface thereof, and then dried.

Electroconductive paste 7 may be, in place of any conventional silver paste, a paste obtained by substituting at least one portion of a silver powder in a conventional silver paste with an electroconductive powder lower in price than the silver powder.

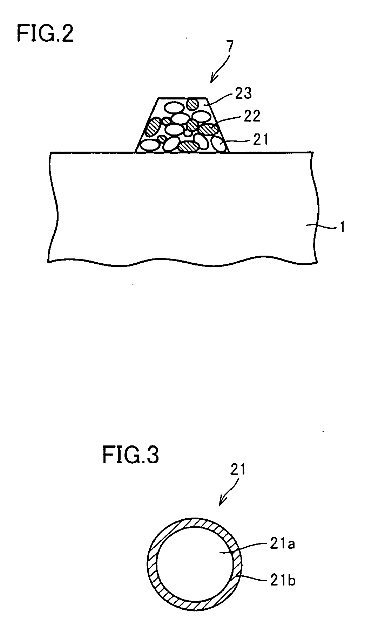

Fig. 2 illustrates a schematic sectional view illustrating an example of electrically conductive paste 7 applied onto the surface of p-type silicon substrate 1. Electrically conductive paste 7 contains an electrically conductive powder made of electrically conductive particles 21, a silver powder made of silver particles 22, and one or more components 23 other than the powders.

Fig. 3 illustrates a schematic sectional view of an example of any one of electrically conductive particles 21 contained in electrically conductive paste 7. Electrically conductive particle 21 includes a basic material 21a, and an electrically conductive layer 21b having electric conductivity and covering at least one portion of the outer surface of basic material 21a.

Basic material 21a may be, for example, alumina (Al₂O₃), silica (SiO₂), silicate glass, nickel, or any other electrically conductive or electrically insulating substance lower in price than silver.

For electrically conductive layer 21b, for example, silver or any other electrically conductive substance may be used. The method for covering at least one portion of the outer surface of basic material 21a with electrically conductive layer 21b may be, for example, electroless plating.

Other component(s) 23 may be, for example, one or more components used in any conventional silver paste, such as glass frit, resin, additives and an organic solvent.

Electrically conductive paste 7 having the above-mentioned formulation may be produced, for example, by mixing the electrically conductive powder made of a plurality of electrically conductive particles 21, the silver powder made of silver particles 22 and other component(s) 23 with each other in a known manner.

The above has described, as an example of electrically conductive paste 7, a paste formed by substituting the silver powder partially with the electrically conductive powder; however, electrically conductive paste 7 may be a paste that does not contain a silver powder at all to contain only the electrically conductive powder.

Next, as illustrated in Fig. 1(f), an aluminum paste 6 is applied onto the second main surface of p-type silicon substrate 1, and then dried. Aluminum paste 6 may be, for example, a paste known in the related art, which contains aluminum powder, glass frit, resin, additives, an organic solvent, and the like. The method for applying aluminum paste 6 may be, for example, screen printing. In the present embodiment, aluminum paste 6 is applied to make a circumferential edge region of the second main surface of p-type silicon substrate 1 uncovered and cause the applied paste to overlap partially with electrically conductive paste 7.

Next, as illustrated in Fig. 1(g), a silver paste 8 is applied onto anti-reflecting film 3 on the first main surface of p-type silicon substrate 1, and then dried. Silver paste 8 may be, for example, a paste known in the related art, which contains glass frit, resin, additives, an organic solvent and the like. The method for applying silver paste 8 may be, for example, screen printing.

Thereafter, aluminum paste 6, electrically conductive paste 7, and silver paste 8 are fired to form, as illustrated in Fig. 1(h), an aluminum electrode 61 and a backside electrode 71 on the second main surface of p-type silicon substrate 1, and further form a light-receiving surface silver electrode 81 on the first main surface of p-type silicon substrate 1.

The formation of aluminum electrode 61 on the second main surface of p-type silicon substrate 1 is attained by firing aluminum paste 6, and the formation of backside electrode 71 is attained by firing electrically conductive paste 7.

The formation of light-receiving surface silver electrode 81 on the first main surface of p-type silicon substrate 1 is attained by firing silver paste 8.

At the time of the firing, aluminum in aluminum paste 6 diffuses the second main surface of p-type silicon substrate 1, whereby a p-type dopant diffused layer 4 is formed in the second main surface of p-type silicon substrate 1.

At the time of the firing, silver paste 8 is fired through, so that silver paste 8 penetrates anti-reflecting layer 3 to form light-receiving silver electrode 81, which is electrically connected to n-type dopant diffused layer 2. As described hereinbefore, a solar cell 10 of Embodiment 1 can be produced.

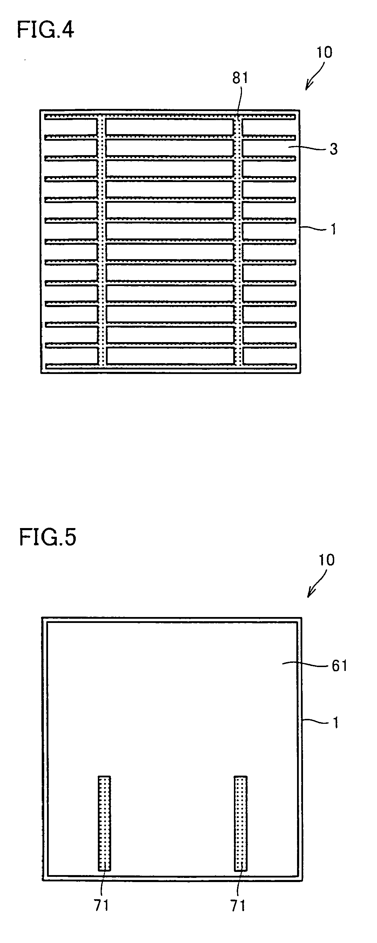

Fig. 4 illustrates a schematic plan view of the light-receiving surface of solar cell 10 of Embodiment 1; and Fig. 5a schematic plan view of the back surface of solar cell 10 of Embodiment 1.

As illustrated in Fig. 4, light-receiving surface silver electrode 81 at the light-receiving surface side of solar cell 10 of Embodiment 1 is formed in a lattice form. As illustrated in Fig. 5, backside electrode 71 at the back surface side of solar cell 10 of Embodiment 1 is formed in a rectangular form. Aluminum 61 is formed to overlap partially with backside electrode 71. The shape of light-receiving surface silver electrode 81 is not limited to that illustrated in Fig. 4, and the respective shapes of aluminum electrode 61 and backside electrode 71 are not limited to those illustrated in Fig. 5.

The step of forming backside electrode 71 by the firing of electrically conductive paste 7 is performed by heating electrically conductive paste 7 to a temperature lower than the melting temperature of electrically conductive particles 21 (and silver particles 22) in electrically conductive paste 7; thus, backside electrode 71 is such a form that electrically conductive particles 21 (and silver particles 22) are aggregated without being melted, and then solidified to be bonded to each other.

Accordingly, even when an electrically insulating material is used as basic material 21a of electrically conductive particles 21 in electrically conductive paste 7, the electroconductivity of backside electrode 71 can be kept by passing electricity into electrically conductive particles 21 through electrically conductive layer 21b, which has electroconductivity, extending throughout the outer surface of basic material 21a of electrically conductive particles 21.

Backside electrode 71 formed by firing electrically conductive paste 7 has an electrode property substantially equivalent to that of a silver electrode formed by firing a silver paste in the related art. It is therefore possible to restrain a rise in the series resistance between backside electrode 71 and the second main surface of p-type silicon substrate 1.

As described above, by the use of, in place of any conventional silver paste, electrically conductive paste 7, which is obtained by substituting at least one portion of a silver powder in the conventional silver paste with an electrically conductive powder lower in price than the silver powder, costs in the production of a solar cell can be decreased while a decline in properties of the solar cell can be restrained as much as possible.

For example, by the use of solar cell 10 of Embodiment 1 in such a manner as described below, a solar cell module can be produced.

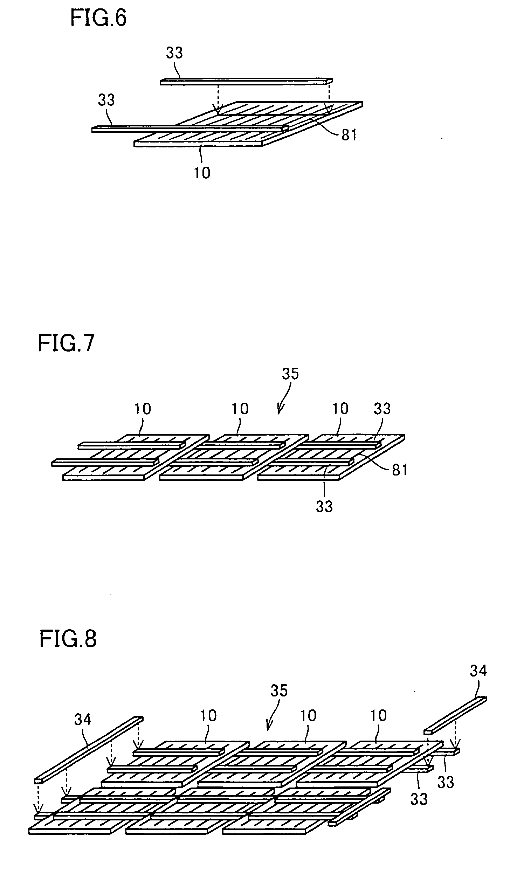

As illustrated in a schematic perspective view of Fig. 6, one end of an interconnector 33, which is an electrically conductive member, is first connected to the upper of light-receiving surface silver electrode 81 of solar cell 10 of Embodiment 1.

Next, as illustrated in a schematic perspective view of Fig. 7, solar cells 10 to which interconnectors 33 are connected are lined up. The other end of interconnector 33 connected to light-receiving surface silver electrode 81 of first one of solar cells 10 is connected to backside electrode 71 at the back surface of one of solar cells 10 that is adjacent to first solar cell 10, and this is successively connected. In this way, a solar cell string 35 is formed.

Next, as illustrated in a schematic perspective view of Fig. 8, solar cell strings 35 are arranged to connect respective interconnectors 33 projected from both ends of first solar cell strings 35, through wiring members 34, which are electrically conductive members, to interconnectors 33 projected from both ends of second solar cell string 35 adjacent to first solar cell string 35. In this way, solar cell strings 35 adjacent to each other are connected to each other in series.

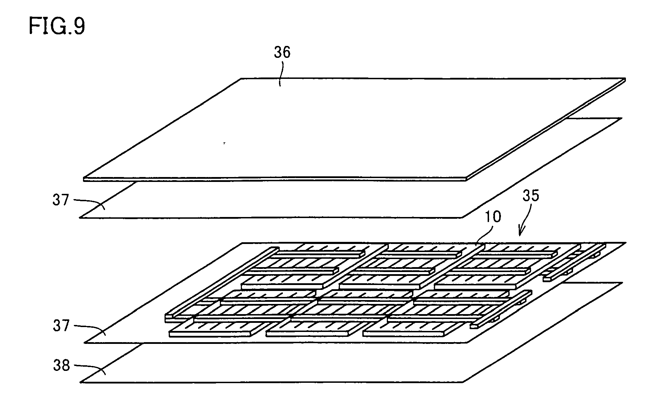

Thereafter, as illustrated in a schematic perspective view of Fig. 9, a matter obtained by sealing solar cell strings 35 connected to each other as described above with a sealing material 37, such as EVA (ethylene vinyl acetate), is sandwiched between a transparent substrate 36, such as a glass substrate, and a backside protecting sheet 38, such as PET (polyethylene terephthalate) film. As described hereinbefore, a solar cell module wherein solar cells 10 of Embodiment 1 are used can be produced.

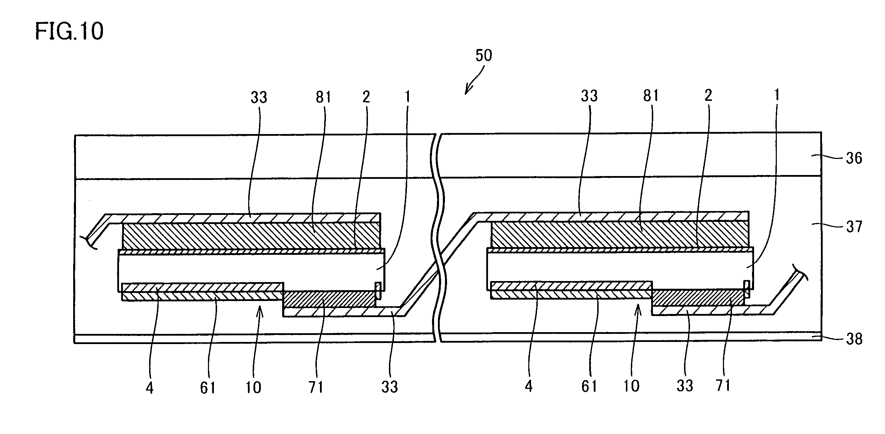

Fig. 10 illustrates a schematic sectional view of the solar cell module example produced as described above, wherein solar cells 10 of Embodiment 1 are used. In a solar cell module 50, solar cells 10 are sealed in sealing material 37 between transparent substrate 36 and backside protecting sheet 38. One end of one of interconnectors 33 is electrically connected to light-receiving surface silver electrode 81 of one of solar cells 10, and the other end of interconnector 33 is electrically connected to backside electrode 71 at the back surface of solar cell 10.

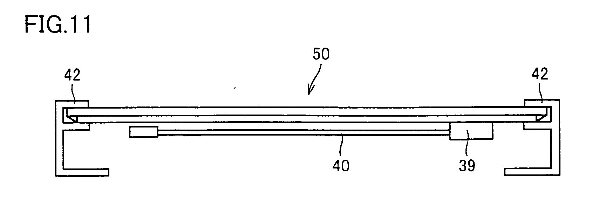

As illustrated in a schematic side view of Fig. 11, an aluminum frame 42 may be fitted to the circumferential edge of solar cell module 50 having the structure illustrated in Fig. 10, and further a terminal box 39 having a cable 40 may be fitted to the back surface of solar cell module 50.

In the above description, the semiconductor substrate of the solar cell(s) is the p-type silicon substrate; however, the semiconductor substrate may be a semiconductor substrate other than any p-type silicon substrate.

### <Embodiment 2>

The present embodiment is **characterized in that** electrically conductive paste 7 is applied not only onto the second main surface of p-type silicon substrate 1 but also onto anti-reflecting film 3 on the first main surface of p-type silicon substrate 1.

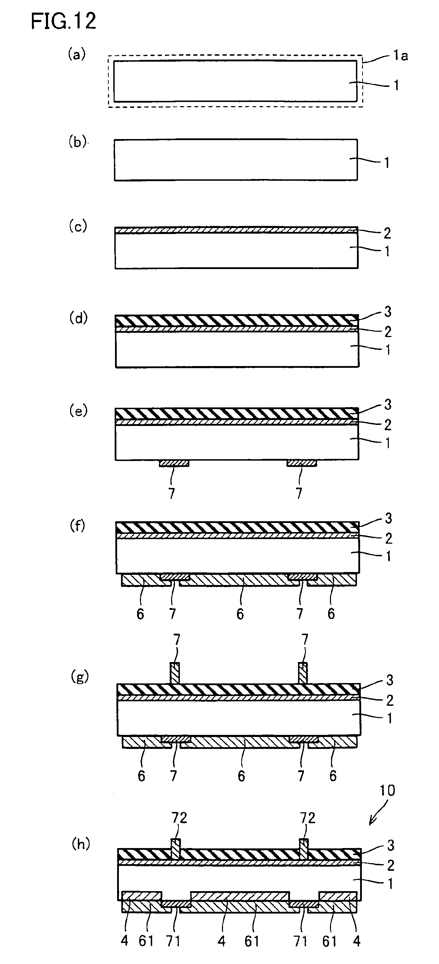

Hereinafter, referring to schematic sectional views of Fig. 12(a) to Fig. 12(h), a description will be made about a method for producing a solar cell of Embodiment 2.

As illustrated in Fig. 12 (a), prepared is first a p-type silicon substrate 1 on each of all surfaces of which a damage layer 1a is formed. Next, as illustrated in Fig. 12(b), all the surfaces of p-type silicon substrate 1 are etched to remove damage layer 1a.

Next, as illustrated in Fig. 12(c), an n-type dopant diffused layer 2 is formed in the first main surface of p-type silicon substrate 1, and then as illustrated in Fig. 12(d), an anti-reflecting layer 3 is formed on n-type dopant diffused layer 2 extending throughout the first main surface of p-type silicon substrate 1.

Next, as illustrated in Fig. 12(e), an electrically conductive paste 7 is applied onto the second main surface of p-type silicon substrate 1, and then dried. Additionally, as illustrated in Fig. 12(f), an aluminum paste 6 is applied onto the second main surface of p-type silicon substrate 1, and then dried. The process up to this step is the same as in Embodiment 1.

Next, as illustrated in Fig. 12(g), electrically conductive paste 7 is applied also onto anti-reflecting layer 3 on the first main surface of p-type silicon substrate 1, and then dried. Electroconductive paste 7 applied on anti-reflecting layer 3 on the first main surface of p-type silicon substrate 1 may be a paste having the same formulation as described above.

Thereafter, aluminum paste 6, electroconductive paste 7 and silver paste 8 are fired, whereby as illustrated in Fig. 12(h), an aluminum electrode 61 and a backside electrode 71 are formed on the second main surface of p-type silicon substrate 1 and additionally a p-type dopant diffused layer 4 is formed in the second main surface of p-type silicon substrate 1. Furthermore, a light-receiving surface electrode 72 is formed on the first main surface of p-type silicon substrate 1. As described above, a solar cell 10 of Embodiment 2 can be produced.

The step of forming light-receiving surface electrode 72 by the firing of electroconductive paste 7 is attained by heating electroconductive paste 7 to a temperature lower than the melting temperature of electroconductive particles 21 (and silver particles 22) in electroconductive paste 7; thus, light-receiving surface electrode 72 comes to have a structure wherein electroconductive particles 21 (and silver particles 22) are aggregated without being melted, and then solidified to be bonded to each other.

Accordingly, even when an electrically insulating material is used as basic material 21a of electrically conductive particles 21 in electrically conductive paste 7, the electroconductivity of light-receiving surface electrode 72 can be kept by passing electricity into electrically conductive particles 21 through electrically conductive layers 21b, which has electroconductivity, extending throughout the outer surface of basic material 21a of electrically conductive particles 21.

Light-receiving surface electrode 72 formed by firing electrically conductive paste 7 has an electrode property substantially equivalent to that of light-receiving surface silver electrode 81, in Embodiment 1, formed by firing the silver paste. It is therefore possible to restrain a rise in the series resistance between light-receiving surface electrode 72 and n-type dopant diffused layer 2 in the first main surface of p-type silicon substrate 1.

As described above, in Embodiment 2, solar cell 10 is produced by applying electrically conductive paste 7 not only onto the second main surface of p-type silicon substrate 1 but also onto anti-reflecting film 3 on the first main surface of p-type silicon substrate 1; therefore, about the solar cell, costs for the production thereof can be made lower than about that of Embodiment 1.

In Embodiment 2, description about others than the above are the same as in Embodiment 1. Thus, the description is omitted.

### <Embodiment 3>

The present embodiment is **characterized in that** electrically conductive paste 7 is not applied onto the second main surface of p-type silicon substrate 1, and electrically conductive paste 7 is applied only onto anti-reflecting film 3 on the first main surface of p-type silicon substrate 1.

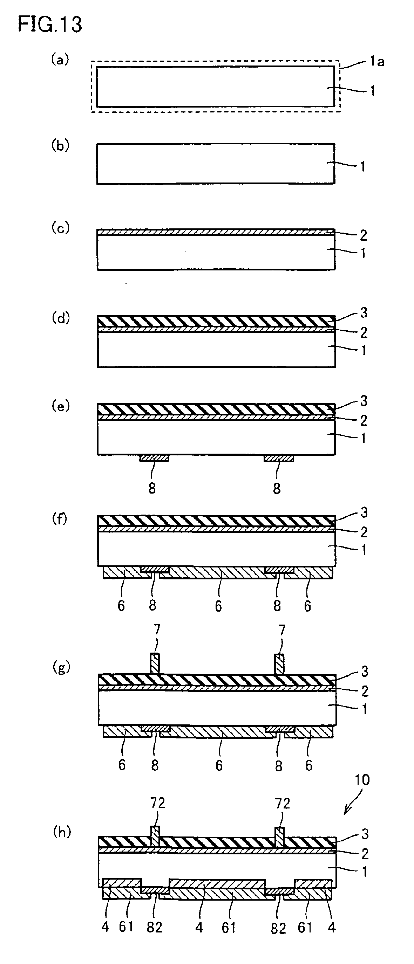

Hereinafter, referring to schematic sectional views of Fig. 13(a) to Fig. 13(h), a description will be made about a method for producing a solar cell of Embodiment 3.

As illustrated in Fig. 13(a), prepared is first a p-type silicon substrate 1 on each of all surfaces of which a damage layer 1a is formed. Next, as illustrated in Fig. 13(b), all the surfaces of p-type silicon substrate 1 are etched to remove damage layer 1a.

Next, as illustrated in Fig. 13(c), an n-ype dopant diffused layer 2 is formed in the first main surface of p-type silicon substrate 1, and then as illustrated in Fig. 13(d), an anti-reflecting layer 3 is formed on n-type dopant diffused layer 2 extending throughout the first main surface of p-type silicon substrate 1. The process up to this step is the same as in Embodiments 1 and 2.

Next, as illustrated in Fig. 13(e), a silver paste 8 is applied onto the second main surface of p-type silicon substrate 1, and then dried. Silver paste 8 applied on the second main surface of p-type silicon substrate 1 may be, for example, a paste having the same formulation as described above.

Next, as illustrated in Fig. 13(f), an aluminum paste 6 is applied onto the second main surface of p-type silicon substrate 1, and then dried. Thereafter, as illustrated in Fig. 13(g), an electrically conductive paste 7 is applied onto anti-reflecting film 3 on the first main surface of p-type silicon substrate 1, and then dried.

Thereafter, aluminum paste 6, electroconductive paste 7 and silver paste 8 are fired, whereby as illustrated in Fig. 13(h), an aluminum electrode 61 and a backside silver electrode 82 are formed on the second main surface of p-type silicon substrate 1 and additionally a p-type dopant diffused layer 4 is formed in the second main surface of p-type silicon substrate 1. Furthermore, a light-receiving surface electrode 72 is formed on the first main surface of p-type silicon substrate 1. As described above, a solar cell 10 of Embodiment 3 can be produced.

As described above, in Embodiment 3, electrically conductive paste 7 is applied onto anti-reflecting film 3 on the first main surface of p-type silicon substrate 1, thereby forming the light-receiving surface electrode of solar cell 10, which is larger in electrode area; therefore, about the solar cell, costs for the production thereof can be made still lower than about that of Embodiment 1.

In Embodiment 3. description about others than the above are the same as in Embodiment 1. Thus, the description is omitted.

### EXAMPLES

### <Example 1>

First, a p-type polycrystal silicon substrate was formed which had two main surfaces in the form of a square having each side 156 mm in length and had a thickness of 200 µm. The p-type polycrystal silicon substrate was formed by slicing a p-type polycrystal silicon ingot with a wire saw, and then etching the workpiece with an alkaline solution to remove any damage layer on the surfaces.

A phosphorus silicate glass liquid (PSG liquid) was applied onto one of the main surfaces of the p-type polycrystal silicon substrate, and then the p-type polycrystal silicon substrate was set in an atmosphere of 900°C temperature to form an n-type dopant diffused layer, resulting from the diffusion of phosphorus, in the one main surface of the p-type polycrystal silicon substrate. The surface resistance of the n-type dopant diffused layer was about 50 Ω/□.

Next, a silicon nitride layer was formed into a thickness of 80 nm onto the n-type dopant diffused layer in the main surface of the p-type polycrystal silicon substrate by plasma CVD.

By the same method as described above, p-type polycrystal silicon substrates were produced in each of which a silicon nitride film was formed on one of its (two) main surfaces. By screen printing, a silver paste having a blend composition A shown in Table 1 described below, and electrically conductive pastes having blend compositions B to G, respectively, were each applied onto one portion of the other main surface of one of these p-type polycrystal silicon substrates, which is a main surface reverse to the silicon-nitride-film-formed-side main surface of the p-type polycrystal silicon substrate. Thereafter, by screen printing, a commercially available aluminum paste was applied onto substantially the whole of the (other) main surface of each of the p-type polycrystal silicon substrates to cause the aluminum paste to overlap partially with the silver paste or the electrically conductive paste. Thereafter, the electrically conductive paste or the silver paste, and the aluminum paste applied onto the (other) main surface of the p-type polycrystal silicon substrate were each dried in an atmosphere of about 150°C temperature.

The silver paste of the blend composition A, and the respective electrically conductive pastes of the blend compositions B to G were each produced by blending components shown in Table 1 into proportions (% by mass) shown in Table 1, kneading the components in a mixer, and then dispersing the electrically conductive powder and/or the silver powder (into the other components) by means of three rollers. The viscosity of the blend composition A, and the respective viscosities of the blend compositions B to G were each set to about 170 Pa·s (measured by use of a viscometer manufactured by Brookfield Co. at a rotational speed of 10 rpm).

As the electrically conductive powder in Example 1, an electrically conductive powder manufactured by ECKA Co. was used: The powder was made of electrically conductive particles which, in the form of an electrically conductive layer made of silver, covered the whole of the outer surface of aluminum basic material in the form of plates each having rectangular surfaces. The electrically conductive particles of the electrically conductive powder used in Example 1 had a median diameter (D50) of 7 µm, and the proportion by mass of the electrically conductive layer made of silver in each of the electrically conductive particles was 30% by mass.

The used glass frit was lead borosilicate glass; the used resin was ethylcellulose; and the used solvent was acetic acid butyl carbitol.

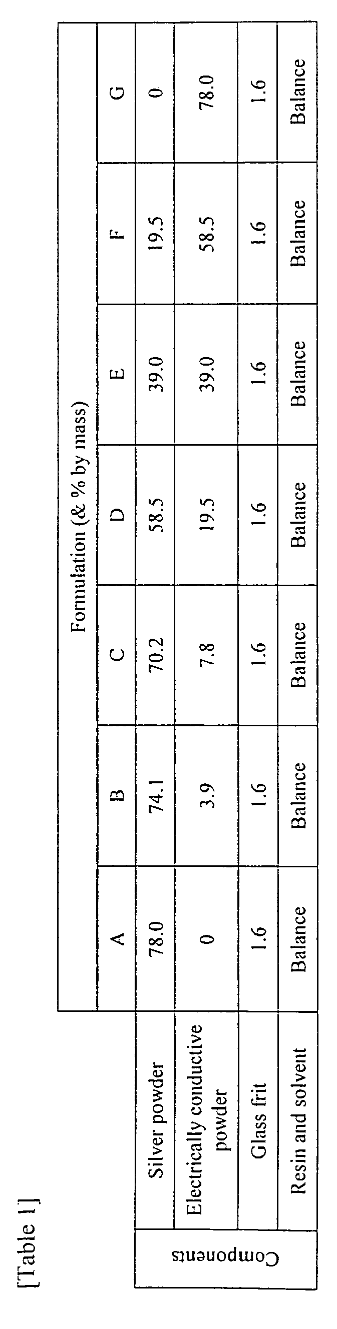

Next, a silver paste having a composition shown in Table 2 described below was printed into a lattice form onto the silicon nitride film on the one main surfaces of each of the p-type silicon substrates by screen printing, and then the silver paste applied on the silicon nitride film on the main surface of the p-type silicon substrate was dried in an atmosphere of about 150°C temperature.

**[Table 2]**

| | | Formulation (& % by mass) |
|---|---|---|
| Components | Silver powder | 80.0 |
| | Glass frit | 4.6 |
| | Resin and solvent | Balance |

Thereafter, the silver paste applied on the one main surface of the p-type silicon substrate was fired at a temperature of 860°C in the air, as well as the aluminum paste, and the electrically conductive paste or the silver paste applied on the other main surface of the p-type silicon substrate.

In this way, the silver paste fired through on the one main surface of the p-type silicon substrate to penetrate the silicon nitride film, so that a silver electrode (light-receiving surface electrode) was formed which was a fired silver paste connected electrically to the n-type dopant diffused layer. Moreover, from the aluminum paste, aluminum was diffused into the other main surface of the p-type silicon substrate so that a p-type dopant diffused layer was formed, and further the following were also formed on the other main surface: an aluminum electrode that was a fired aluminum paste; and a silver electrode (backside electrode) that was a fired electrically conductive paste or silver a paste.

As described above, solar cells of Samples 1 to 7 were produced which each had the light-receiving surface electrode made of the silver electrode, and each had, on the back surface thereof, the aluminum electrode, and the backside electrode made of the silver electrode. The solar cell of Sample 1 was a solar cell having the backside electrode formed by use of the silver paste of the blend composition A. The solar cells of Samples 2 to 7 were solar cells having the backside electrodes by use of the electrically conductive pastes of the blend compositions B to G, respectively.

Next, in the state that the whole of the backside-electrode-side main surface of each of the solar cells of Samples 1 to 7 produced as described above was adsorbed onto an electrically conductive stage, the light-receiving-surface-side main surface thereof was irradiated with quasi-sunlight, thereby measuring the current-voltage characteristic of each of the solar cells of Samples 1 to 7. The maximum power thereof was then calculated out. The results are shown in an electrical characteristic row in Table 3.

The electrical characteristic row in Table 3 shows the relative value of the maximum power of each of the solar cells of Samples 2 to 7 when the maximum power of the solar cell of Sample 1 was regarded as 100.

A (backside electrode) blend composition row in Table 3 shows the blend composition of each of the silver paste and the electrically conductive pastes used to form the respective backside electrodes.

An electrically conductive powder occupation proportion (%) row in Table 3 shows the proportion (% by mass) of the mass of the electrically conductive powder in the total mass of the silver powder and the electrically conductive powder in the silver paste of the blend composition A. as well as the proportion (% by mass) of the mass of the electrically conductive powder in the total mass of the silver powder and the electrically conductive powder in the electrically conductive paste of each of the blend compositions B to G.

**[Table 3]**

| | Sample 1 | Sample 2 | Sample 3 | Sample 4 | Sample 5 | Sample 6 | Sample 7 |
|---|---|---|---|---|---|---|---|
| Blend composition (backside electrode) | A | B | C | D | E | F | G |
| Electrically conductive powder occupation proportion (%) | 0 | 5 | 10 | 25 | 50 | 75 | 100 |
| Electrical characteristic | - | 99 or more | 99 or more | 99 or more | 99 or more | 99 or more | 99 or more |

As shown in Table 3, the respective electrical characteristics of the solar cells of Samples 2 to 7 were equivalent to that of the solar cell of Sample 1. Therefore, about the solar cells of Samples 2 to 7 having the backside electrodes formed by use of the electrically conductive pastes of the blend compositions B to G, respectively, these pastes being each a paste wherein at least one portion of a silver powder is substituted with an electrically conductive powder lower in price than the silver powder, the following was verified: these solar cells can be produced at lower costs than the solar cell of Sample 1 having the backside electrode formed by use of the silver paste of the blend composition A in the related art while the solar cells of Samples 2 to 7 keep an electrical characteristic decline equivalent to that of the solar cell of Sample 1.

### <Example 2>

Solar cells of Samples 8 to 14 were produced in the same way as in Example 1 except that instead of the silver paste of the blend composition shown in Table 2, a silver paste of a blend composition H shown in Table 4 described below, and electrically conductive pastes of blend compositions I to N shown therein were used to form their light-receiving surface electrodes, respectively. The electrically conductive particles used in the respective electrically conductive pastes of the blend compositions I to N were the same electrically conductive particles as in Example 1.

About each of the solar cells of Samples 8 to 14, the current-voltage characteristic thereof was measured in the same way as in Example 1, and then the maximum power thereof was calculated out. The results are shown in an electrical characteristic row in Table 5.

The electrical characteristic row in Table 5 shows the relative value of the maximum power of each of the solar cells of Samples 9 to 14 when the maximum power of the solar cell of Sample 8 was regarded as 100.

A (backside electrode) blend composition row in Table 5 shows the blend composition of each of the silver paste and the electrically conductive pastes used to form the respective backside electrodes.

A (light-receiving surface electrode) blend composition row in Table 5 shows the blend composition of each of the silver paste and the electrically conductive pastes used to form the respective light-receiving surface electrodes.

An electrically conductive powder occupation proportion (%) row in Table 5 shows the proportion (% by mass) of the mass of the electrically conductive powder in the total mass of the silver powder and the electrically conductive powder in the silver paste of the blend composition H, as well as the proportion (% by mass) of the mass of the electrically conductive powder in the total mass of the silver powder and the electrically conductive powder in the electrically conductive paste of each of the blend compositions I to N.

The solar cell of Sample 8 corresponds to a cell wherein the silver paste of the blend composition A was used to form the backside electrode and further the silver paste of the blend composition H was used to form the light-receiving surface electrode. The solar cells of Samples 9 to 14 correspond to cells wherein the electrically conductive pastes of the blend compositions B to G were used, respectively, to form their backside electrodes, and further the electrically conductive pastes of the blend compositions I to N were used, respectively, to form their light-receiving surface electrodes.

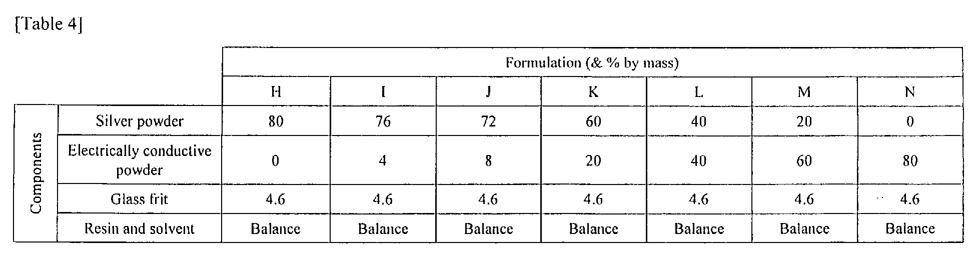

**[Table 5]**

| | Sample 8 | Sample 9 | Sample 10 | Sample 11 | Sample 12 | Sample 13 | Sample 14 |
|---|---|---|---|---|---|---|---|
| Blend composition (backside electrode) | A | B | C | D | E | F | G |
| Blend composition (light-receiving surface electrode) | H | I | J | K | L | M | N |
| Electrically conductive powder occupation proportion (%) | 0 | 5 | 10 | 25 | 50 | 75 | 100 |
| Electrical characteristic | - | 99 or more | 99 or more | 99 or more | 99 or more | 99 or more | 98 or more |

As shown in Table 5, the respective electrical characteristics of the solar cells of Samples 9 to 14 were equivalent to that of the solar cell of Sample 8. Therefore, about the solar cells of Samples 9 to 14 having the backside electrodes formed by use of the blend compositions B to G, respectively, and having the light-receiving surface electrodes formed by use of the blend compositions I to N, respectively, these compositions being compositions wherein at least one portion of a silver powder is substituted with an electrically conductive powder lower in price than the silver powder, the following was verified: these solar cells can be produced at by far lower costs than the solar cell of Sample 8 having the backside electrode and the light-receiving surface electrode formed by use of the silver pastes of the blend compositions A and H in the related art, respectively, while the solar cells of Samples 9 to 14 keep an electrical characteristic decline equivalent to that of the solar cell of Sample 8.

### <Example 3>

Solar cells of Samples 15 to 26 were produced in the same way as in Example 1 except that the silver paste of the blend composition shown in Table 2 described above was used to form their backside electrodes, and further the electrically conductive pastes of the blend compositions N, L and I show in Table 4 described above and electrically conductive pastes of blend compositions O to W shown in Table 6 described below were used to form their light-receiving surface electrodes, respectively. For the electrically conductive particles used in the respective electrically conductive pastes of the blend compositions O to W, basic materials shown in Table 7 described below are used, respectively, and further electrically conductive powder manufactured by ECKA Co. was used, this powder being made of electrically conductive particles which covered, in the form of electrically conductive layers made of silver, the whole of the outer surface of each of the basic materials. The electrically conductive particles in the respective electrically conductive pastes of the blend compositions O to W used in Example 3 had a median diameter (D50) of 7 µm, and the proportion by mass of the electrically conductive layer made of silver in each of the electrically conductive particles was 30% by mass.

About each of the solar cells of Samples 15 to 26, the current-voltage characteristic thereof was measured in the same way as in Example 1, and then the maximum power thereof was calculated out. The results are shown in respective electrical characteristic rows in Tables 8 and 9.

The electrical characteristic row in each of Tables 8 and 9 shows the relative value of the maximum power of each of the solar cells of Samples 15 to 26 when the maximum power of the solar cell of Sample 8 was regarded as 100.

A (light-receiving surface electrode) blend composition row in each of Tables 8 and 9 shows the blend composition of each of the electrically conductive pastes used to form the respective light-receiving surface electrodes.

An electrically conductive powder occupation proportion (%) row in each of Tables 8 and 9 shows the proportion (% by mass) of the mass of the electrically conductive powder in the total mass of the silver powder and the electrically conductive powder in each of the electrically conductive pastes of the blend compositions N, L and I, and O to W.

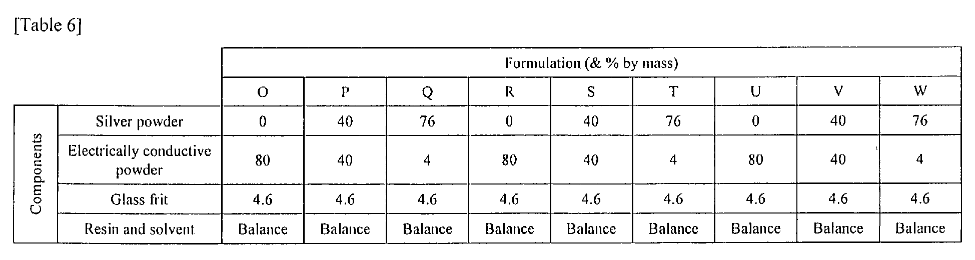

**[Table7]**

| | Blend composition | | | | | | | | |
|---|---|---|---|---|---|---|---|---|---|
| | O | P | Q | R | S | T | U | V | W |
| Basic material | Silica | Silica | Silica | Glass | Glass | Glass | Nickel | Nickel | Nickel |

**[Table 8]**

| | Sample 15 | Sample 16 | Sample 17 | Sample 18 | Sample 19 | Sample 20 |
|---|---|---|---|---|---|---|
| Blend composition (light-receiving surface electrode) | N | L | I | O | P | Q |
| Electrically conductive powder occupation proportion (%) | 100 | 50 | 5 | 100 | 50 | 5 |
| Electrical characteristic | 98 or more | 99 or more | 99 or more | 98 or more | 99 or more | 99 or more |

**[Table 9]**

| | Sample 21 | Sample 22 | Sample 23 | Sample 24 | Sample 25 | Sample 26 |
|---|---|---|---|---|---|---|
| Blend composition (light-receiving surface electrode) | R | S | T | U | V | W |
| Electrically conductive powder occupation proportion (%) | 100 | 50 | 5 | 100 | 50 | 5 |
| Electrical characteristic | Less than 98 | 98 or more | 99 or more | 98 or more | 98 or more | 99 or more |

As shown in Tables 8 and 9, the respective electrical characteristics of the solar cells of Samples 15 to 20, and 22 to 26 were equivalent to that of the solar cell of Sample 8. Therefore, about the solar cells of Samples 15 to 20 and 22 to 26 having the light-receiving surface electrodes formed by use of the electrically conductive pastes of the blend compositions N, L, I, O to Q, and S to W, respectively, these pastes being each a paste wherein at least one portion of a silver powder is substituted with an electrically conductive powder lower in price than the silver powder, the following was verified: these solar cells can be produced at by far lower costs than the solar cell of Sample 8 having the backside electrode and the light-receiving surface electrode formed by use of the silver pastes of the blend compositions A and H in the related art, respectively, while the solar cells of Samples 15 to 20, and 22 to 26 keep an electrical characteristic decline equivalent to that of the solar cell of Sample 8.

### <Example 4>

Solar cells of Samples 27 and 28 were produced in the same way as in Example 1 except that their backside electrodes were formed by use of the silver paste of the blend composition shown in Table 2 described above, and further their light-receiving surface electrodes were formed by use of electrically conductive pastes of blend compositions X and Y, respectively. The blend compositions X and Y were compositions wherein the proportion of the mass of the electrically conductive layer made of silver in the mass of each of the electrically conductive particles in the electrically conductive powder of the blend composition L shown in Table 4 described above was changed to 5% by mass, and 10% by mass, respectively, as shown in Table 10 described below.

About each of the solar cells of Samples 27 and 28, the current-voltage characteristic thereof was measured in the same way as in Example 1, and then the maximum power thereof was calculated out. The results are shown in an electrical characteristic row in Table 11.

The electrical characteristic row in Table 11 shows the relative value of the maximum power of each of the solar cells of Samples 27 and 28 when the maximum power of the solar cell of Sample 8 was regarded as 100.

An Ag coat proportion (%) row in Table 10 shows the proportion (%) of the mass of the electrically conductive layer made of silver in the mass of each of the electrically conductive particles in the electrically conductive paste of each of the blend compositions X and Y.

**[Table 10]**

| | Blend composition | |
|---|---|---|
| | X | Y |
| Ag coat proportion (%) | 5 | 10 0 |

**[Table 11]**

| | Sample 27 | Sample 28 |
|---|---|---|
| Blend composition (light-receiving surface electrode) | X | Y |
| Electrical characteristic | Less than 98 | 98 or more |

As shown in Table 11, the electrical characteristic of the solar cell of Sample 28 was equivalent to that of the solar cell of Sample 8. Therefore, about the solar cell of Sample 28 having the light-receiving surface electrode formed by use of the electrically conductive paste of the blend composition Y, which is a composition wherein at least one portion of a silver powder is substituted with an electrically conductive powder lower in price than the silver powder, the following was verified: the solar cell of Sample 28 can be produced at by far lower costs than the solar cell of Sample 8 having the backside electrode and the light-receiving surface electrode formed by use of the silver pastes of the blend compositions A and H in the related art, respectively, while the solar cell of Sample 28 keeps an electrical characteristic decline equivalent to that of the solar cell of Sample 8.

The embodiments and the working examples disclosed herein are mere examples in all respects, and should be interpreted not to be restrictive. The scope of the invention is specified not by the above-mentioned description but by the claims, and is intended to include all variations having a meaning and a scope equivalent to those of the claims.

### INDUSTRIAL APPLICABILITY

The invention may be used for an electrically conductive paste, an electrode for a semiconductor device, a semiconductor device, and a method for producing a semiconductor device.

### REFERENCE SIGNS LIST

1: p-type silicon substrate, 1a: damage layer, 2: n-type dopant diffused layer, 3: anti-reflecting layer, 4: p-type dopant diffused layer, 6: aluminum paste, 7: electrically conductive paste, 8: silver paste, 10: solar cell, 21: electrically conductive particles, 21a: basic material, 21b: electrically conductive layer, 22: silver particles, 23: other component(s), 33: interconnector, 34: wiring member, 35: solar cell string, 36: transparent substrate, 37: sealing material, 38: backside protecting sheet, 39: terminal box, 40: cable, 42: aluminum frame, 50: solar cell module, 61: aluminum electrode, 71: backside electrode, 72: light-receiving surface electrode, 81: light-receiving surface silver electrode, 82: backside silver electrode, 100: p-type silicon substrate, 200: n-type dopant diffused layer, 300: silicon nitride layer, 400: p-type dopant diffused layer, 600: aluminum paste, 601: backside aluminum electrode, 700: backside silver paste, 701: backside silver electrode, 800: light-receiving surface silver paste, and 801: light-receiving surface silver electrode

## Claims

1. An electrically conductive paste (7) containing an electrically conductive powder comprising electrically conductive particles (21),
wherein said electrically conductive particles (21) each have:
a basic material (21a), and
an electrically conductive layer (21b) covering at least one portion of the outer surface of said basic material (21a).

2. The electrically conductive paste (7) according to claim 1, further containing a silver powder comprising silver particles (22).

3. An electrode (71, 72, 81, 82), for a semiconductor device, containing electrically conductive particles (21),
wherein said electrically conductive particles (21) each have:
a basic material (21a), and
an electrically conductive layer (21b) covering at least one portion of the outer surface of said basic material (21a).

4. A semiconductor device (10, 35) containing a semiconductor substrate (1), and
an electrode (71, 72, 81, 82), for the semiconductor device, that is set over a surface of said semiconductor substrate (1),
wherein said electrode (71, 72, 81, 82), for the semiconductor device, contains electrically conductive particles (21), and
said electrically conductive particles (21) each have:
a substrate (21a), and
an electrically conductive layer (21b) covering at least one portion of the outer surface of said basic material (21a).

5. A method for producing a semiconductor device (10, 35), comprising the steps:
applying an electrically conductive paste (7) containing an electrically conductive powder comprising electrically conductive particles (21) to a semiconductor substrate (1), and
firing said electrically conductive paste (7).
